Europäisches Patentamt

European Patent Office

Office européen des brevets

(19)

(11) Numéro de publication : **0 494 013 A1**

# (12) DEMANDE DE BREVET EUROPEEN

(21) Numéro de dépôt : **91403509.2**

(22) Date de dépôt : **20.12.91**

(51) Int. Cl.$^5$ : **H01L 33/00, H01S 3/085, H01S 3/025, H01S 3/25**

(30) Priorité : **28.12.90 FR 9016432**

(43) Date de publication de la demande :
**08.07.92 Bulletin 92/28**

(84) Etats contractants désignés :
**DE GB**

(71) Demandeur : **THOMSON-CSF
51, Esplanade du Général de Gaulle
F-92800 Puteaux (FR)**

(72) Inventeur : **Faist, Jérôme
THOMSON-CSF, SCPI, Cédex 67
F-92045 Paris la Défense (FR)**
Inventeur : **Reinhart,Franz-Karl
THOMSON-CSF, SCPI, Cédex 67
F-92045 Paris la Défense (FR)**

(74) Mandataire : **Guérin, Michel et al
THOMSON-CSF SCPI
F-92045 PARIS LA DEFENSE CEDEX 67 (FR)**

(54) **Procédé de réalisation de lasers semiconducteurs à émission de surface et lasers obtenus par le procédé.**

(57) L'invention concerne un procédé de réalisation de diode laser à émission de surface à puits quantiques multiples, comportant une seule opération épitaxiale et une seule opération d'implantation et diffusion d'impuretés dopantes. Les dimensions latérales du laser sont définies par application d'un masquage (3) sur la région active (10) avant l'implantation d'impuretés dopantes tout autour de la région active (10), évitant l'étape de gravure chimique classique avec ces conséquences néfastes sur l'espérance de vie du laser fini. La construction du laser selon le procédé de l'invention permet d'optimiser séparément les caractéristiques de confinement optique (selon l'axe de propagation de la lumière) et de confinement de porteurs de charge dans la région active (10) (perpendiculaire à l'axe de propagation). Les épaisseurs des couches épitaxiales d'un premier miroir distribue de type Bragg et des couches (8,6) de la région active (puits quantiques (8) et couches intercalaires (6) ou super réseaux) sont choisies pour optimiser les gains (dans chaque puits quantique) et pour minimiser les pertes (surtout dans le miroir) de façon à optimiser le courant de seuil et le rendement énergétique du laser. L'invention concerne également des lasers réalisés selon le procédé. De tels lasers seront particulièrement adaptés à l'utillsation en réseau de diodes lasers, commandées individuellement ou non.

FIG.8

EP 0 494 013 A1

La présente invention concerne les procédés de réalisation de lasers semiconducteurs à émission de surface et les lasers ainsi réalisés.

Le procédé selon l'invention sera utilisé avantageusement pour la réalisation de plusieurs lasers sur le même substrat, formant ainsi un réseau de lasers. Selon une caractéristique, ces lasers peuvent être commandés individuellement.

Un laser semiconducteur est essentiellement constitué par un milieu actif de type cristallin où la lumière est émise par recombinaison radiative des électrons et des trous. Le milieu actif est placé dans une cavité optique résonante formée par deux miroirs réfléchissants, dont l'un au moins est partiellement transparent pour permettre à une partie de la lumière émise à l'intérieur de la cavité optique d'émerger de cette cavité. Les électrons et les trous sont introduits dans le milieu actif par des régions de type "n" et de type "p" qui sont disposées en contact avec le milieu actif.

Plusieurs variantes de laser semiconducteur sont connues de l'art antérieur, utilisant différents milieux actifs, différents miroirs, différents matériaux p et n, différentes dimensions ou encore des géométries différentes. Les principes de base restent les mêmes dans tous les cas.

Le milieu actif peut être réalisé, par exemple, à base d'arseniure de gallium, de phosphure d'indium ou d'autres composés III-V ; ou encore, des composés II-VI ou IV-VI pourraient servir aussi de milieu actif malgré la technologie moins mature.

Le point essentiel est que le milieu actif doit avoir une bande interdite d'énergie électronique plus faible que la bande interdite des matériaux n et p adjacents qui fournissent les électrons et les trous.

Les miroirs peuvent être réalisés en métal (conducteurs), ou en multicouches diélectriques ou semiconducteurs. Dans certaines réalisations, un miroir peut aussi servir à amener du courant vers le milieu actif.

Les contraintes de la solution choisie pour la réalisation d'un laser semiconducteur auront des répercussions sur les coûts et le rendement de fabrication ; sur la reproductibilité et la fiabilité des lasers réalisés ; et sur le rendement énergétique des lasers, donc sur la consommation du courant, la dissipation thermique, et la durée de vie des lasers.

De façon générale, on cherche à fabriquer un laser avec un gain le plus élevé pour un courant donné, ou un courant de seuil le plus faible pour un gain donné. Dans ce but, le laser à puits quantiques multiples (PQM) présente des avantages certains car le courant de seuil est réduit en proportion au volume de la région active.

En gros, il faut injecter environ $10^7 A/cm^3$ de courant dans la région active pour exciter l'effet laser. Pour une couche de 0,1 micron, par exemple, le courant de seuil est de l'ordre de $10^3 A/cm^2$. Dans un laser classique à hétérostructure double, l'épaisseur des couches épitaxiales dans la région active est de l'ordre de un à quelques centaines de nanomètres. Dans un laser PQM, les couches actives sont épaisses de quelques nanomètres, et la densité du courant de seuil est réduit par environ un ordre de grandeur.

Cependant, pour bénéficier de cet avantage, il faut réaliser un laser PQM avec de très faibles pertes et donc de très bons miroirs. De plus, la structure cristalline du milieu actif doit être parfaite : tout défaut de maille condamne le laser à une mort précoce.

Ceci conduit à utiliser des méthodes de croissance épitaxiale ou monocristalline telles, par exemple, celles des composés métallo-organiques en phase vapeur (MOCVD en anglais), ou encore, celle de l'épitaxie par jet moléculaire (MBE en anglais), de façon à contrôler l'épaisseur des couches épitaxiales à la précision d'une couche atomique, tout en assurant un taux de défauts de maille cristalline aussi réduit que possible. D'autres techniques de croissance sont envisageables, mais ne sont pas encore entièrement validées en milieu industriel, telles l'épitaxie par jet chimique (CBE en anglais), et l'épitaxie par jet moléculaire des composés métallo-organiques (MOMBE en anglais).

De chaque côté du milieu actif, des miroirs sont placés de façon à créer une cavité dans laquelle la lumière laser est amplifiée. L'un au moins des deux miroirs sera semi réfléchissant, semi transparent de manière à pouvoir extraire une partie de la puissance lumineuse de l'intérieur de la cavité vers une utilisation externe.

Pour les lasers PQM à émission de surface, de très bons miroirs sont requis pour obtenir des pertes aussi faibles que possible à l'intérieur de la cavité.

Les miroirs peuvent être du métal déposé directement sur les couches de la région active, ou encore du diélectrique, donc isolateur. Dans le cas de l'invention, une réalisation préférée non limitative utilise des miroirs constitués par empilement de différentes couches de diélectrique pour faire un miroir dit "de Bragg". Dans un miroir de Bragg, chaque couche de diélectrique de quelques 1/10 de micron d'épaisseur seulement, est hautement transparente. L'empilement de couches alternées de compositions et d'indices de réfraction différentes provoque la réflexion aux interfaces entre ces couches monocristallines obtenues par la croissance épitaxiale, due à la différence des indices. Dans le cas des hétérostructures épitaxiées avec désaccord de maille entre les composés constituant des couches successives, celles-ci peuvent être construites en super réseaux où le désaccord de maille est insuffisant pour entraîner la création de défauts à l'interface des couches de composés différents, à condition que les couches soient assez minces (quelques couches atomiques).

La lumière est constituée des photons provenant de la recombinaison radiative des paires électron-trou. Les porteurs, des électrons et des trous, sont fournis à la région active par des matériaux n et p au voisinage immédiat et en contact physique avec la région active. Pour un rendement optimum, la distance à parcourir avant recombinaison pour un trou comme pour un électron, doit être inférieur à une longueur de diffusion de porteur, de l'ordre de un à quelques microns. Ce paramètre peut être déterminant des dimensions maximales de la région active.

Aussi pour optimiser le rendement du laser, il faut minimiser les pertes dues à des recombinaisons non radiatives, qui ont lieu de préférence sur les surfaces libres de la région active.

L'amplification laser par l'émission stimulée de radiation est obtenue par la présence des photons dans la région active, photons qui doivent être confinés à la région active pour obtenir cet effet amplificateur. Les photons sont confinés par les miroirs dans le sens de l'émission (perpendiculaire à la surface du laser dans le cas de la présente invention) ; des photons dans tout autre sens de propagation ne sont pas confinés et donc ne sont pas amplifiés. Autrement dit, seule l'émission dans le bon sens est stimulée, par la présence d'une population de photons dans l'état quantique correspondant.

Le renvoi des photons dans la région active par des miroirs donne une rétroaction qui renforce l'émission des photons identiques et donc l'amplification de lumière dans la région active. Ce renvoi des photons peut être obtenu par des miroirs qui consiste en plusieurs couches transparentes avec indices de réfraction différentes, la rétroaction est alors dite "répartie", et les miroirs sont appelés des réflecteurs répartis de Bragg.

Mais le renvoi des photons peut être aussi obtenu par réflexions partielles entre les couches à l'intérieur de la région active elle-même. les lasers sont alors appelés des lasers à rétro action répartie.

Pour résumer, nous avons vu que, pour faire un laser à l'état solide, il faut fournir des porteurs (électrons et trous) à une région active où ils seront confinés jusqu'à leur recombinaison radiative, d'une part ; et d'autre part, les photons résultants doivent être confinés à la région active suffisamment longtemps pour obtenir la stimulation d'émission.

Le premier problème rencontré dans la réalisation de lasers à émission de surface est de confiner les photons et les porteurs dans la région active, alors que le sens du courant et de l'émission de lumière est le même dans la plupart des cas.

Une première solution connue de l'art antérieur par le brevet français 88 16215, par exemple, est de faire venir du courant par les côtés de la région active, de façon à pouvoir optimiser de façon indépendante les conceptions optiques et électriques, comme dans des lasers classiques à émission par les bords.

D'autres solutions sont également connues de l'art antérieur, mais avec chacune leurs inconvénients. Les premiers réseaux de diodes laser à émission de surface ont été réalisés à Bell labs à Holmded, et à Bellcore à Red Bank (USA). Pour diminuer le volume de la région active et donc le courant de seuil, les lasers réalisés en grande quantité sur un seul substrat (jusqu'à 2 millions de lasers par cm²) sont séparés et leurs diamètres définis par une gravure anisotrope profonde (jusqu'à 5 microns de profondeur pour des lasers de 1 à 5 microns de diamètre). Le gros problème de cette méthode est que les lasers sont à l'air libre sur les côtés (ils ont la forme d'un cylindre vertical, d'axe parallèle à l'émission). La gravure a tendance à abîmer la structure cristalline de la partie attaquée, et laisse des défauts cristallins sur les bords de la région active.

De plus, la recombinaison non radiative est plus forte sur les côtés libres de la région active. Finalement, pour l'intégration en réseau, éventuellement avec commande individuelle, il serait souhaitable de remplir l'espace entre les lasers, jusqu'à la planarisation. Ceci pourrait améliorer le refroidissement des lasers, ainsi que servir de support pour les pistes électriques de commande ; aussi la recombinaison non radiative doit être réduite en conséquence de la réduction de la surface libre.

Dans l'art antérieur, on connaît deux méthodes pour remplir l'espace entre les lasers. Une méthode consiste à faire une planarisation sur la plaque comportant le réseau de lasers, en déposant une matière par des techniques de la croissance épitaxiale, par exemple. Une telle méthode s'avère délicate de réalisation, car la profondeur à remplir est de l'ordre de 5 microns, alors que la largeur de l'espace entre les lasers est souvent de l'ordre de 1 à 2 microns seulement.

Une autre méthode connue de l'art antérieur consiste à réaliser le laser par les moyens d'épitaxie mentionnés ci-dessus, et ensuite à réaliser des sources de trous et d'électrons de chaque côté de la région active par la diffusion d'impuretés ("dopants") p et n respectivement dans la matière entourant la région active.

Cette méthode est décrite dans la demande de brevet français portant le numéro national 88 16215 au nom de la demanderesse.

Suivant cette méthode, les impuretés ou dopants p et n sont diffusés respectivement chacun dans une semi coquille entourant de moitié chaque diode laser. Cette méthode a l'inconvénient de demander plusieurs étapes (au moins deux mais peut être plus) d'implantation et de diffusion d'impuretés suivant une géométrie précise et alternée.

La présente invention a pour but de remédier aux inconvénients des procédés de fabrication de lasers à émission de surface connus de l'art antérieur. Plus précisément, le procédé selon l'invention cherche à simplifier les étapes de fabrication et à en réduire le nombre ; réduisant ainsi les coûts de fabrication en augmentant le rendement de fabrication, tout en assurant les meilleures performances des lasers ainsi réalisés : gain, courant de seuil, consomnnation d'énergie électrique, reproductibilité, fiabilité, longévité...

A ces fins, l'invention propose un procédé de fabrication de diodes laser à émission de surface, comprenant essentiellement les étapes suivantes :

– croissance épitaxiale sur un substrat monocristallin d'un miroir de Bragg monocristallin ; le substrat et le miroir étant dopés type n ;

– croissance monocristalline d'au moins une couche épitaxiale d'un premier composé d'une bande interdite $E_2$ ;

– éventuellement croissance monocristalline épitaxiale d'une couche d'un deuxième composé d'une bande interdite $E_1 \leqq E_2$ ;

– croissance épitaxiale monocristalline (multicouche) d'un milieu actif ayant des dimensions transversales supérieures à celles du milieu actif du laser à obtenir ; cette croissance peut être conçue pour réaliser une multiplicité de puits quantiques par exemple, ou, au contraire, pour réaliser un super réseau de couches de différents composés mais avec accord de maille, ou encore, on peut alterner les deux ;

– croissance monocristalline d'une couche épitaxiale d'un composé d'une bande interdite $E_1$, $E_1 \leqq E_2$ ;

– éventuellement croissance monocristalline épitaxiale d'une couche d'un premier composé d'une bande interdite $E_2$ ;

– masquage local de la surface de la dernière couche épitaxiée pour définir les dimensions latérales de la région active ;

– implantation et/ou diffusion d'impuretés de type p dans la région autour de la région active, en dehors de la région masquée par l'étape précédente, et à une profondeur jusqu'à la première couche épitaxiale de bande interdite $E_2$ ;

– dépôt de contacts ohmiques métalliques sur la dernière couche épitaxiée et sous le substrat ;

– dépôt d'un miroir semi réfléchissant au-dessus de la région active, par exemple un miroir multicouche diélectrique, en couches alternées de $SiO_2$ et de $TiO_2$.

L'ordre des étapes est donné pour une réalisation préférée non limitative, mais n'exclut pas l'exécution dans un ordre différent ou avec des étapes complémentaires ajoutées au procédé selon l'invention. Par ailleurs, les première et seconde couche épitaxiale peuvent être d'un seul composé et donc une seule couche.

Le procédé selon l'invention permet ainsi de simplifier et de réduire sensiblement le nombre d'opérations à effectuer pour la réalisation d'un laser diode à émission de surface, tout en assurant les meilleures performances du dispositif ainsi obtenu. La cavité optique ainsi que la région active peuvent être réalisées dans une seule opération d'hétéroépitaxie, simplifiant considérablement la fabrication d'un laser à émission de surface. De plus, le procédé est particulièrement adapté pour la réalisation de réseaux de diodes lasers en deux dimensions, autorisant de nouvelles applications telles que des liaisons optiques parallèles à haute densité et à haut débit, à l'intérieur même des super calculateurs d'une génération future.

D'autres avantages et caractéristiques de la présente invention apparaîtront au cours de la description suivante avec ses dessins annexes, donnés à titre d'exemples non limitatifs, dans lesquels :

– la figure 1 représente schématiquement et en coupe la partie électrique d'une diode laser à l'état solide ;

– la figure 2 représente schématiquement et en coupe la partie optique d'une diode laser à émission de surface ;

– les figures 3a et 3b représentent schématiquement et en coupe une diode laser connue de l'art antérieur : la figure 3b représente un détail de la région active de la figure 3a ;

– La figure 4 représente schématiquement en coupe et en perspective, une diode laser à émission de surface connue de l'art antérieur ;

– la figure 5 représente schématiquement et en coupe longitudinale les premières étapes dans la réalisation d'un exemple d'une diode laser à émission de surface selon l'invention ;

– la figure 6 représente schématiquement et en coupe longitudinale une autre étape dans la réalisation d'un exemple d'une diode laser à émission de surface selon l'invention ;

– la figure 7 représente schématiquement et en coupe longitudinale une autre étape dans la réalisation d'un exemple d'une diode laser à émission de surface selon l'invention ;

– la figure 8 représente schématiquement et en coupe longitudinale d'un exemple une diode laser à émission de surface réalisé selon le procédé de l'invention.

Les figures représentent des exemples non limitatifs de réalisations, sur lesquelles les mêmes repères désignent les mêmes éléments sur les différentes figures. D'autres réalisations selon l'invention où ses principales caractéristiques seront facilement imaginées par l'homme de l'art.

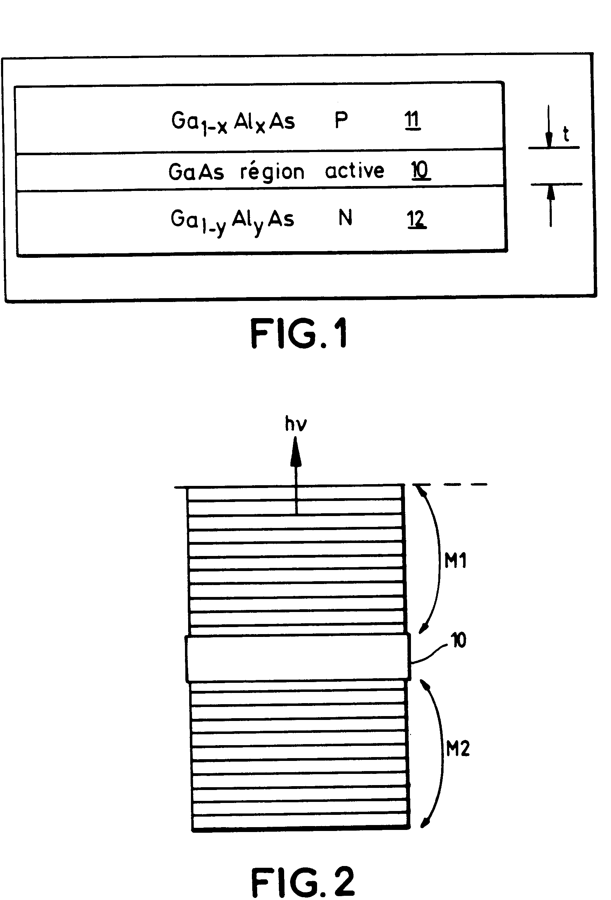

Sur la figure 1, l'on voit que la région active 10 d'une diode laser est entourée par un matériau 11 de type p, et un autre matériau 12 de type n. Les matériaux 11 de type p et 12 de type n fournissent, respectivement, des trous et des électrons à la région active, où ils seront recombinés en émettant de la lumière.

A titre d'exemple, la région active 10 peut être du GaAs, la région p (11) en $Ga_{1-x}Al_x As$, et la région n (12) en $Ga_{1-y}Al_y As$, où x et y ont des valeurs comprises entre 0 et 1.

Sur la figure 2, l'on voit que la région active 10 d'une diode laser à émission de surface est placée dans une cavité optique qui consiste en deux miroirs M1 et M2 ; dont l'un au moins M1 est partiellement transparent pour laisser la lumière laser h*nu sortir selon l'axe de la région active et de la cavité optique, telle qu'indiqué sur la figure par la flèche verticale. Dans l'exemple de la figure 2, les deux miroirs M1 et M2 sont constitués par empilement de couches successives de matériaux avec indices de réfraction différents. Ceci peut être réalisé, par exemple, par des couches de GaAs alternées avec des couches GaAlAs ; ou encore par empilement de couches diélectriques telles $SiO_2$ alternées avec des couches $TiO_2$, par exemple. Dans une variante connue de l'art antérieur, les miroirs M1, M2 peuvent être partiellement ou entièrement réalisés à l'intérieur même de la région active.

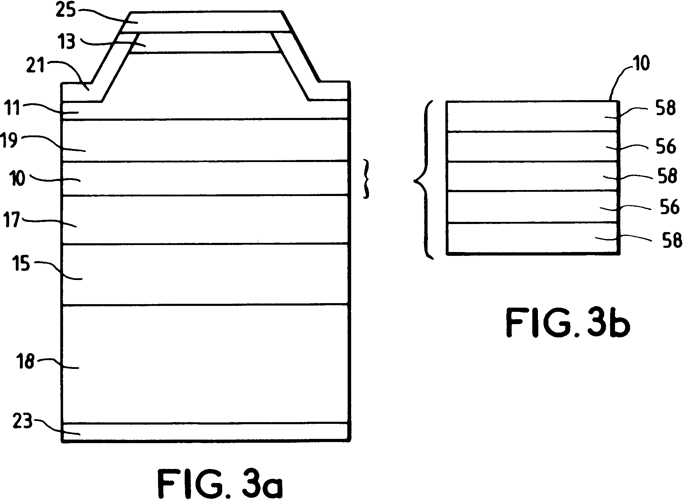

Sur les figures 3a et 3b, l'on voit un exemple d'une diode laser connue de l'art antérieur. La figure 3a montre la réalisation de couches successives épitaxées sur le substrat 18, en GaAs, par exemple, dopé n à une concentration de l'ordre de $10^{18}/cm^3$. Dans les exemples discutés à l'aide des figures, l'on utilise surtout des exemples sur l'utilisation du GaAs et du GaAlAs pour former les couches successives de la région active, mais d'autres composés binaires, ternaires ou quaternaires des groupes III-V, II-VI, ou IV-VI peuvent être utilisées indifféremment pour réaliser l'invention. Quelques exemples de substitutions possibles seraient : InP, GaInAsP, GaAsInP,... PbSnTe.

Sur la figure 3a, on voit la première couche épitaxiale 15 qui sera, par exemple, de GaAlAs et dopée n à une concentration de l'ordre de $10^{18}/cm^3$ comme le substrat. La deuxième couche 17 est également en GaAlAs dans cet exemple, mais dopée n⁻. Sur cette deuxième couche 17 la région active 10 est ensuite réalisée. La structure de la région active est montrée en détail sur la figure 3b.

Sur la région active 10, une troisième couche épitaxiale 19 de GaAlAs est déposée, et dopée p⁻. Ensuite une quatrième couche épitaxiale 11 de GaAlAs est réalisée et dopée p. Finalement, une cinquième couche épitaxiale 13 est réalisée en GaAs et dopée p⁺.

Les compositions des couches entourant la région active sont choisies de façon à donner une largeur de bande interdite plus élevée autour de la région active 10 qu'à l'intérieur de cette région, pour fournir l'énergie de pompage au laser par les porteurs provenant des régions dopées n et p. Dans l'exemple de la figure 3, la région active 10 est composée de couches alternées de GaAs 58 et de GaAlAs 56 telle que montrée sur le détail 3b. L'épaisseur des couches 56 et 58 est inférieur à 20 nm, ce qui en fait des "puits quantiques".

Un puits quantique est formé par une région de largeur de bande interdite plus faible, entourée par des régions de largeur de bande plus élevée, de façon à confiner des porteurs libres dans la région de largeur de bande interdite plus faible. Dans les puits quantiques de dimensions très réduites, la densité d'états accessibles aux porteurs est réduite par rapport à celle d'un matériau massif.

Une étape de photolithographie suivie par une gravure profonde déterminent les dimensions latérales du laser fini, typiquement de l'ordre d'un micron de largeur. Le dessin montre le laser en coupe longitudinale sur l'axe de propagation de la lumière émise ; la géométrie du laser pourrait être de symétrie de révolution autour de cet axe, ou encore, le laser peut avoir une géométrie carrée ou rectangulaire dans un plan parallèle au substrat. Les dimensions latérales seront aussi réduites que possibles, car le courant de seuil de fonctionnement laser est proportionnel au volume de la région active.

Des contacts ohmiques métalliques 21, 23 sont réalisés sur les extrémités du laser pour fournir l'énergie électrique aux zones de porteurs libres. La couche 23, déposée sur le côté du substrat 18 opposée aux couches épitaxiales, doit servir également de miroir dans cet exemple ; elle sera réalisée de préférence en Au,Ti,... Le contact fourni sur la partie supérieure du laser sur les faces inclinées, définies par gravure peut être réalisé en Au, Ti, Al... Ensuite un miroir semi réfléchissant 25 est déposé sur la dernière couche épitaxiale 13. Ce miroir peut être par exemple une multicouche diélectrique, dont les couches alternées ont des indices de réfraction différentes, par exemple des couches de $SiO_2$ alternées avec des couches de $TiO_2$.

La figure 3 représente schématiquement un exemple qui est sans doute la plus simple construction connue de l'art antérieur. Cependant, des compromis de conception sont inévitables dans une telle disposition dès lors que les porteurs de charges électriques et les photons de la lumière laser sont confinés à circuler dans le même sens (parallèle à l'axe de la structure), avec le confinement latéral étant réalisé essentiellement par l'étendue latérale de la structure elle-même.

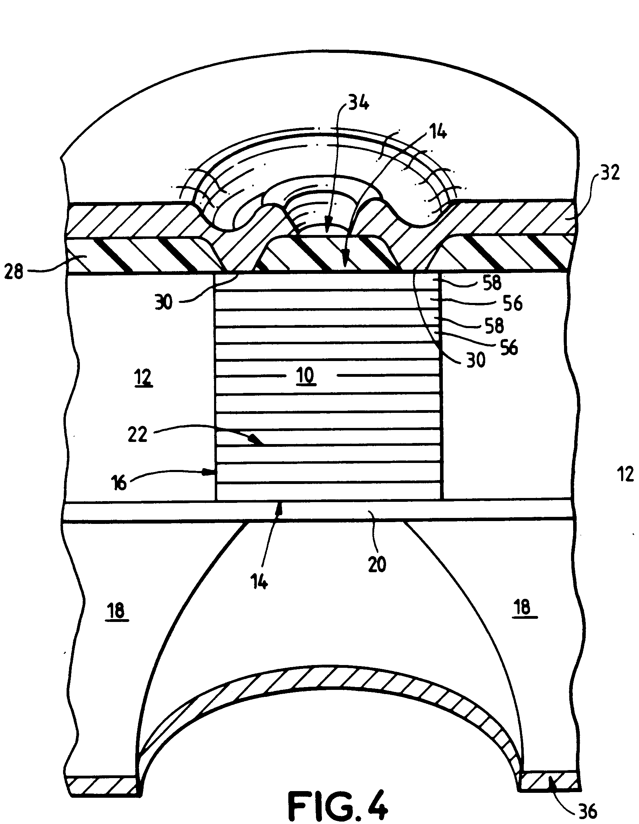

La figure 4 représente schématiquement un autre exemple d'une réalisation connue de l'art antérieur, dans lequel la jonction diode (n,p) est plutôt dans le sens radial, perpendiculaire au sens de la propagation de la lumière laser. La région active 10 est composée d'une succession de couches alternées GaAs/GaAlAs comme dans le cas précédent, mais cette région 10 de type p est entourée latéralement d'un matériel 12 de type n.

Comme dans le cas de la figure 3, le substrat 18 est avantageusement mais non exclusivement de GaAs, dopé dans ce cas n⁺ à un niveau de l'ordre de $2*10^{18}/cm^3$. La couche 20 de GaAlAs type n a le rôle d'arrêter la gravure effectuée dans le substrat après réalisation du laser pour minimiser l'absorption de lumière laser par le substrat, car les miroirs 14 ne sont que partiellement réfléchissants.

Le procédé de réalisation de la région de confinement 12 utilise une gravure pour définir la région active, qui est au départ réalisée avec des dimensions latérales supérieures aux dimensions finales, en empilant des couches épitaxiales successives alternées de l'AsGa 58, GaAlAs 56, dopées d'impuretés type p à un niveau de $2*10^{17}/cm^3$. La gravure sélective des couches laisse une colonne d'un diamètre de 5 microns environ. Ensuite, la région de confinement, en matériau GaAlAs dopé n à $2*10^{17}/Cm^3$ est déposée autour de la région active à une profondeur sensiblement égale à la hauteur de la colonne.

La couche d'isolation 28 de $SiO_2$ est déposée et une fenêtre annulaire 30 est gravée jusqu'à la surface supérieure de la région active 10. Après diffusion de zinc à travers cette fenêtre annulaire vers la surface supérieure de la colonne, un contact électrique 32 de Pt/Au/Ti est déposée à travers un masquage, et une autre couche métallique 36 du Au/Ge est déposée sur la surface inférieure du substrat 18.

L'exemple de la figure 4 est peut être d'une structure qui ressemble le plus à la structure réalisable par le procédé selon l'invention, mais nous verrons combien le procédé selon l'invention simplifie, et réduit le nombre d'étapes de réalisation requis.

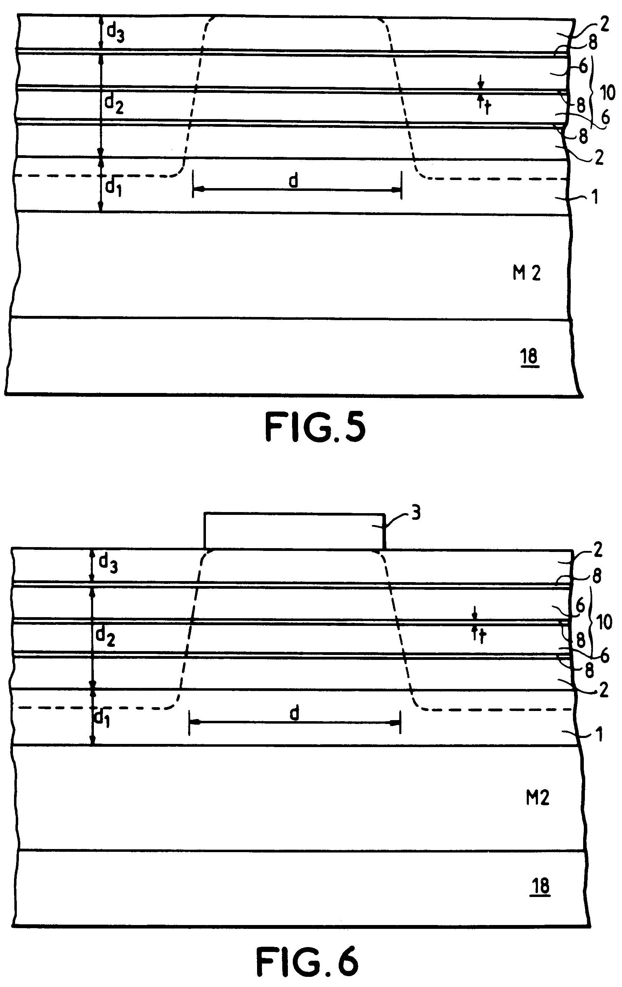

La figure 5 représente schématiquement et en coupe les premières étapes dans la réalisation d'un exemple d'une diode laser à émission de surface selon l'invention. Le laser peut avoir une symétrie de révolution, étant circulaire dans le plan des couches épitaxiées, ou peut être de forme rectangulaire dans ce même plan.

Un miroir Bragg monocristallin M2 est composé de couches alternées de composés différents élaborées par croissance épitaxiale ou monocristalline selon les méthodes connues de l'homme de l'art sur un substrat monocristallin 18. A titre d'exemple, dans une réalisation préférée, le substrat 18 peut être du GaAs, et le miroir de Bragg peut être composé de couches alternées de AsGa et de GaAlAs. Bien entendu, d'autres combinaisons de composés différents pourraient être choisies parmi les éléments des groupes III-V, II-VI, ou IV-VI. Les couches du miroir M2 et le substrat 18 seront dopés n, par exemple, suivant les méthodes connues de l'homme de l'art, pour permettre d'emmener des électrons vers la région active dans le dispositif fini.

Ensuite, une première couche épitaxiale 1, d'un premier composé d'une épaisseur $d_1$ et d'une bande interdite $E_2$ est déposée sur le miroir M2. Les compositions de la couche 1 et de la dernière couche supérieure du miroir M2 seront choisies pour permettre un accord de maille cristalline à leur interface, pour minimiser l'apparition de défauts qui seraient nuisibles aux performances du dispositif fini. La couche 1, ainsi que les couches qui suivront, est de dimensions latérales plus importantes que celles de la région active (les dimensions latérales de la région active, dont l'étendue $d$ est indiquée sur les figures 5 à 8 par des pointillés, sont celles dans le plan des couches, perpendiculaire à la direction de propagation de la lumière émise de la surface du laser).

Dans une réalisation préférée, une deuxième couche épitaxiale 2 d'un deuxième composé ayant une bande interdite $E_1 < E_2$, sera élaborée toujours en croissance monocristalline avec accord de maille et essentiellement sans défaut d'interface.

Sur la couche 2, la région active 10 proprement dite sera ensuite élaborée, toujours par croissance monocristalline et avec accord de maille. La région active 10, dans le cas de la présente invention, est composée d'une pluralité de puits quantiques 8, ce qui consiste à empiler plusieurs (N) couches actives minces (épaisseur $t$ de l'ordre de quelques nanomètres, par exemple) séparées par des couches intercalaires 6 de l'ordre de 100-120 nm d'épaisseur (par exemple). Ces couches alternées, actives 8 et intercalaires 6 respectivement, de compositions différentes, sont de dimensions latérales supérieures à celles ($d$) de la région active du dispositif fini.

L'épaisseur $t$ des couches actives 8 est minimisée, pour minimiser le courant de seuil qu'il faudrait injecter pour obtenir l'effet laser, ce courant étant proportionnel au volume actif. Dans une réalisation préférée, l'épaisseur des couches intercalaires, ainsi que les dimensions $d_1$ et $d_3$ sont choisies pour correspondre à la longueur d'onde de la lumière laser, confinée en onde stationnaire à l'intérieur de la région active par les miroirs ; les couches actives 8 sont placées aux endroits ou l'intensité de champ de l'onde stationnaire est maximale, les noeuds de l'onde se trouvant entre les couches actives 8. Cette disposition permet de gagner le maximum d'amplification lumineuse par stimulation de radiation dans les couches actives.

Dans une autre réalisation préférée, les couches intercalaires 6 seront réalisées par une construction en super réseaux cristallin. Dans un super réseau, la maille cristalline des couches minces alternées, même de composés différents, aura une valeur unique et donc n'engendrera pas de défauts d'interfaces.

La bande interdite d'un super réseaux sera approximativement la moyenne des bandes interdites des composés constituant les couches minces alternées.

On choisira la composition des couches actives 8 et intercalées 6 pour donner la longueur d'onde de lumière laser souhaitée, par exemple, du GaInAs et du GaInAsP pour obtenir une radiation à 1,3 microns. Dans une autre réalisation préférée, on empile des couches de l'AsGa alternées avec des couches de l'AlGaAs.

Après le dépôt du dernier puits quantique de la région active, une dernière couche 2, de composition identique à la couche 2 précédente, peut être déposée sur la dernière couche active 8 de la région active ; cette couche sera élaborée selon les mêmes techniques de croissance monocristalline.

On peut donner des exemple de dimensions indiquées sur la figure 5 pour situer les ordres de grandeur à titre d'exemple non limitatif ; dans l'exemple de GaAs et une longueur d'onde de 850 nm, et sachant que l'indice de réfraction dans GaAs est n = 3,5, l'épaisseur $d_1$ de la couche 1 est de même ordre de grandeur que l'épaisseur $d_3$ de la couche 2, approximativement 120 nm. L'épaisseur $d_2$ de la région active est approximativement N*120 nm, ou N est un nombre entier, le nombre de puits quantiques (N < 10). La largeur ou le diamètre de la région active, $d$, est de l'ordre de un à quelques microns. Dans le cas de InP, avec indice de réfraction n = 3,3 et longueur d'onde de 1 300 ou 1 500 nm, les dimensions $d_1$ et $d_3$ sont de l'ordre de 200 nm, et $d_2$ approximativement N * 200 nm.

Dans une autre réalisation préférée non montrée, plusieurs (M) couches actives peuvent être regroupées autour de chaque maximum de champ, pour augmenter l'amplification du dispositif ; mais en augmentant ainsi le volume actif total (N * M * $d^2$ * $t$),le courant de seuil est aussi augmenté en proportion. Pour cette raison, on cherche = minimiser le nombre de puits quantiques N* M autant que possible, compte tenu des pertes du dispositif.

La figure 6 montre une prochaine étape de fabrication, qui consiste à poser un masque 3 protecteur de la région active sur la surface exposée de celle-ci. Ce masque sera de $Si_3N_4$, par exemple, ou de $Al_2O_3$, ou un autre composé transparent à la longueur d'onde d'émission laser, et aura les dimensions latérales $d$ de la région active finale. Dans la réalisation préférée montrée sur les figures 6 à 8, ce masquage transparent restera dans le dispositif fini. Cependant, dans une autre réalisation, un masquage provisoire pourrait être réalisé, en métal, en diélectrique, ou en résine par exemple. Ce masquage provisoire pourrait être ensuite retiré après l'étape de diffusion d'impuretés autour de la région active, laissant la dernière couche épitaxiée sur laquelle le miroir semi réfléchissant M1 serait ensuite déposé.

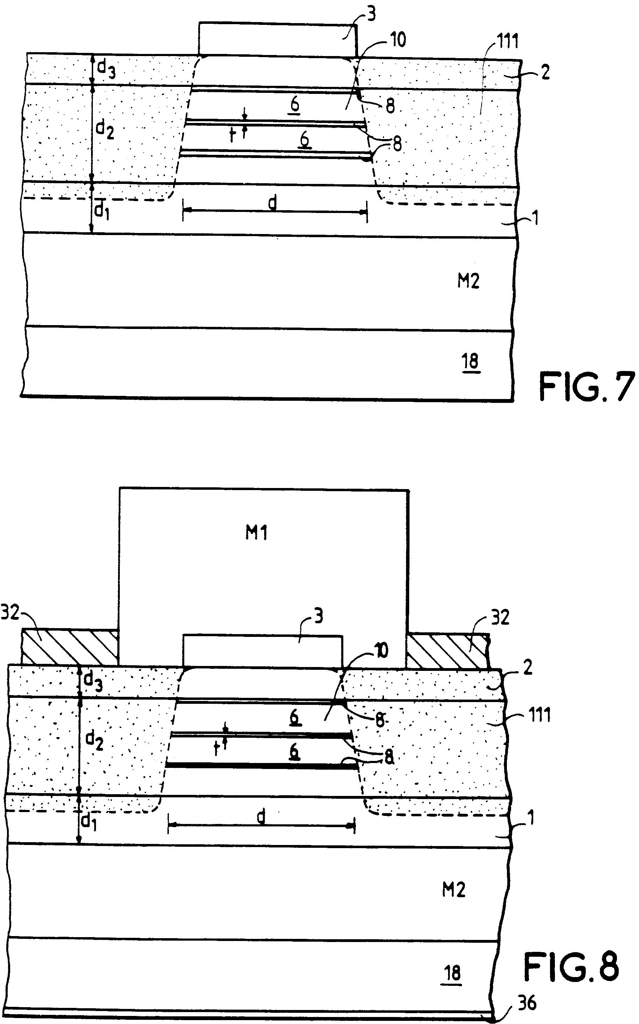

Sur la figure 7 est illustrée une prochaine étape de fabrication, qui consiste à introduire une impureté dopante de type P par la surface supérieure du dispositif, tout autour de la région active. Le masque 3 est de nature à protéger la région active de la diffusion de cette impureté dopante, qui sera, par exemple, du Zn ou du Cd. La diffusion de cette impureté dopante a aussi un effet secondaire et non le moindre, car la présence de cette impureté permet l'interdiffusion ou la migration entre les différentes couches épitaxiées, à conditions quelles soient suffisamment minces, des éléments des composés de ces couches, avec pour résultat une homogénéisation de la composition de la région ainsi diffusée. Cet effet est connu par les Anglophones par le sigle IID : Impurity Induced Diffusion. Dans un exemple de compositions cité ci-dessus, l'aluminium dans les couches intercalaires de GaAlAs sera rendu mobile et se diffusera dans les couches actives de GaAs, effaçant la structure des couches empilées dans la région dopée, tout autour de la région active. Ceci est indiqué sur le dessin de la région 111 en dehors des pointillés et comportant les petits points qui représentent les impuretés (à une concentration de l'ordre de $10^{18}$ / cm$^3$).

Dans une variante équivalente du procédé selon l'invention, le substrat 18 et miroir M2 sont dopés type P, et la région autour de la région active est dopée type N.

Les couches actives sont d'un composé ayant une largeur de bande interdite $E_o < E_1 \leqq E_2$. La diffusion d'impureté dopante dans la région extérieure et tout autour de la région active provoque l'interdiffusion des composés des couches différentes, ayant des bandes interdites $E_o$ et $E_1$ avant interdiffusion. La valeur de l'énergie de la bande interdite du composé résultant de l'interdiffusion sera une moyenne $E_m$ des deux bandes interdites initiales $E_1$ et $E_o$, pondérée par leurs concentrations relatives dans le composé homogène résultant. Il en résulte que l'énergie de bande interdite des couches actives dans la région active $E_o$ est inférieure $E_m$, et donc les porteurs de charge seront confinés dans la région active jusqu'à leur recombinaison radiative. De plus, l'interdiffusion a pour résultat un changement de l'indice de réfraction optique, ce qui aide à confiner les photons localement dans la région active (indice de réfraction plus élevée dans la région active que dans la région diffusée).

La figure 8 montre schématiquement les dernières étapes de fabrication par exemple d'un laser à émission de surface selon l'invention, ainsi que le dispositif final résultant. D'abord les contacts ohmiques métalliques 32 et 36 sont déposés sur les surfaces supérieures et inférieures du laser, l'étendu des contacts étant définie au préalable par masquage ou par la suite par gravure.

Ensuite le miroir M1 semi réfléchissant est construit, en multicouches diélectriques, par exemple. Dans une réalisation préférée, ce miroir est fabriqué par empilage des couches de $SiO_2$ et de $TiO_2$. Ce miroir permet à la fois le confinement des photons dans la cavité optique, et aussi le prélèvement de la lumière laser vers une utilisation externe.

Dans le procédé selon l'invention, il n'y a qu'une seule opération d'hétéroépitaxie en croissance monocristalline : le miroir distribué de Bragg, les régions passive et active. L'interdiffusion des couches actives et intercalaires en dehors et tout autour de la région active, induite par adjonction d'impureté dopante, remplit trois fonctions : d'établir une région type p capable de fournir des trous, de confiner latéralement les porteurs libres et les photons dans la région active, et d'éviter la recombinaison non radiative sur les bords de la région active. Les lasers peuvent ainsi être fabriqués en grand nombre sur un seul substrat, avec un nombre d'étapes de fabrication sensiblement réduit par rapport à l'art antérieur, et avec des performances meilleures.

De plus, le procédé selon l'invention est facilement adapté, avec l'adjonction d'une seule étape, à la fabrication de réseaux de diodes lasers dans lesquelles les lasers peuvent être commandés individuellement. Pour se faire, les lasers sont séparés par une gravure anisotrope profonde, selon les méthodes connues de l'homme de l'art : gravure chimique, ablation laser, érosion ionique, ... La gravure traversera la couche 2, la région p homogène 111, pour s'arrêter dans la couche 1 ou le miroir M2. Dans une étape suivante, les contacts ohmiques 32 sont déposés par sérigraphie, photolithographie, ou tout autre procédé à la portée de l'homme de l'art, selon une configuration de pistes qui permet un adressage des lasers du réseau.

**Revendications**

1. Procédé de réalisation de laser à émission de surface, dont l'émission lumineuse est selon une direction $z$ perpendiculaire à la surface dudit laser, comprenant les étapes suivantes :

   – croissance épitaxiale sur un substrat (18) monocristallin d'un miroir Bragg (M2) monocristallin constitué des couches alternées de composés différents, ledit substrat et ledit miroir étant dopés d'une première impureté apte à créer dans la région dopée des porteurs libres d'un premier type ;
   – croissance monocristalline d'au moins une couche épitaxiale (1) d'un premier composé d'une bande interdite $E_2$ ;
   – croissance épitaxiale monocristalline multicouches d'un milieu actif (10) comportant une pluralité de puits quantiques (8) délimités et séparés par des couches intercalaires (6) d'un composé d'une bande interdite $E_1$, lesdits puits quantiques (8) étant des couches minces d'un autre composé de bande interdite $E_o$ $< E_1 \leqq E_2$, ledit milieu actif multicouches ayant des dimensions transversales (perpendiculaires à la direction $z$) supérieures à celles de la région active du laser à obtenir ;
   – croissance monocristalline d'une dernière couche épitaxiale (2) d'un composé ayant une bande interdite $E_1 \leqq E_2$ .
   – masquage d'une partie de la surface de la dernière couche de la région active pour définir les dimensions transversales de la région active ;

   – implantation et diffusion d'une deuxième impureté dans la région (111) autour de la région active masquée par l'étape précédente, à une profondeur (parallèle à la direction $z$) jusqu'à la première couche épitaxiale (1) de bande interdite $E_2$, ladite deuxième impureté apte à créer dans la région (111) dopée des porteurs libres d'un deuxième type différent dudit premier type ;
   – déposition de contacts ohmiques métalliques (32,36) sur la dernière couche épitaxiée (2) de bande interdite $E_1$ et en contact électrique avec celle-ci, d'une part, et sous le substrat (18) et en contact électrique avec celui-ci, d'autre part ;
   – déposition d'un miroir (M1) semi réfléchissant au-dessus de la région active.

2. Procédé de réalisation de laser à émission de surface selon la revendication 1, caractérisé en ce que ladite impureté de type n est du silicium.

3. Procédé de réalisation de laser à émission de surface selon des revendications 1 à 2, caractérisé en ce que ladite impureté de type p est du zinc ou du cadmium

4. Procédé de réalisation de laser à émission de surface selon l'une quelconque des revendications 1 à 3, caractérisé en ce que lesdites couches alternées différentes dudit miroir Bragg (M2) sont composées des mêmes éléments dans des proportions différentes.

5. Procédé de réalisation de laser à émission de surface selon l'une des revendications 1 à 4, caractérisé en ce que lesdits puits quantiques (8) et lesdites couches intercalaires (6) ont des dimensions sensiblement différentes selon la direction $z$.

6. Procédé de réalisation de laser à émission de surface selon l'une quelconque des revendications 1 à 5, caractérisé en ce que lesdites couches intercalaires (6) sont constituées de couches minces empilées en super réseaux.

7. Procédé de réalisation de laser à émission de surface selon l'une quelconque des revendications 1 à 6, caractérisé en ce que ledit masquage (3) est une couche de diélectrique transparente.

8. Procédé de réalisation de laser à émission de surface selon la revendication 7, caractérisé en ce que ladite couche (3) de diélectrique transparente est constituée de $Sl_3N_4$ ou $Al_2O_3$.

9. Procédé de réalisation de laser à émission de surface selon l'une quelconque des revendications 1 à 8, caractérisé en ce que ladite diffusion d'une deuxième impureté dans ladite région (111) autour de ladite région active (10) est obtenue par chauffage.

10. Procédé de réalisation de laser à émission de surface selon la revendications 9, caractérisé en ce que ledit chauffage est obtenu au moyen d'un rayonnement électromagnétique comme celui donné par un laser ou analogue.

11. Procédé de réalisation de laser à émission de surface selon l'une quelconque des revendications 1 à 10, caractérisé en ce que ledit miroir semi réfléchissant (M2) est un miroir diélectrique constitué par empilement des couches alternées de compostions différentes.

12. Laser semiconducteur à émission de surface réalisé selon l'une quelconque des revendications 1 à 11.

13. Réseau d'une pluralité de lasers semiconducteur à émission de surface selon la revendication 12, caractérisé en ce que lesdits lasers sont réalisés sur un seul et unique substrat.

14. Réseau de lasers semiconducteur à émission de surface selon la revendication 13, caractérisé en ce que lesdits lasers sont isolés les uns des autres par une gravure anisotrope profonde.

15. Réseau de lasers semiconducteur à émission de surface selon la revendication 14, caractérisé en ce que lesdits lasers isolés comprennent des contacts ohmiques, ces contacts ohmiques étant en contact électrique avec des pistes électriques dont la configuration permet un adressage individuel de chaque laser dudit réseau.

$Ga_{1-x} Al_x As$     P     $\underline{11}$

GaAs région active     $\underline{10}$

$Ga_{1-y} Al_y As$     N     $\underline{12}$

t

FIG.1

hν

M1

10

M2

FIG.2

EP 0 494 013 A1

FIG. 3a

FIG. 3b

FIG. 4

FIG.5

FIG.6

FIG.7

FIG.8

Office européen
des brevets

**RAPPORT DE RECHERCHE EUROPEENNE**

Numero de la demande

EP    91 40 3509

Page 1

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | PATENT ABSTRACTS OF JAPAN<br>vol. 11, no. 288 (E-542)17 Septembre 1987<br>& JP-A-62 086 883 ( MATSUSHITA ELECTRIC IND. CO. LTD. )<br>* abrégé * | 1,3,12 | H01L33/00<br>H01S3/085<br>H01S3/025<br>H01S3/25 |
| A | EP-A-0 177 617 (JAPAN REPRESENTED BY THE PRESIDENT OF TOHOKU UNIVERSITY)<br>* page 18, ligne 14 - page 21, ligne 18 *<br>* page 24, ligne 1 - page 24, ligne 20; figures 5-9,13 * | 1,3,4,<br>12,13,14 | |
| A | APPLIED PHYSICS LETTERS.<br>vol. 56, no. 20, 14 Mai 1990, NEW YORK US<br>pages 1942 - 1944;<br>HOI-JUN YOO ET AL.: 'Low series resistance vertical-cavity front-surface-emitting laser diode'<br>* le document en entier * | 1,4,7,12 | |
| A | PATENT ABSTRACTS OF JAPAN<br>vol. 13, no. 348 (E-799)4 Août 1989<br>& JP-A-1 108 789 ( SHARP CORP. )<br>* abrégé * | 1,3,7,12 | **DOMAINES TECHNIQUES RECHERCHES (Int. Cl.5)**<br><br>H01S |
| A | US-A-4 949 351 (KOICHI IMANAKA)<br>* colonne 3, ligne 56 - colonne 4, ligne 2; figures 1-3 * | 1,4,12 | |
| A | ELECTRONICS LETTERS.<br>vol. 26, no. 13, 21 Juin 1990, STEVENAGE, HERTS., GB<br>pages 940 - 942;<br>C.J.CHANG-HASNAIN ET AL.: 'Surface emitting laser arrays with uniformly separated wavelengths'<br>* le document en entier * | 1,4,12,<br>13 | |

-/--

Le présent rapport a été établi pour toutes les revendications

| Lieu de la recherche | Date d'achèvement de la recherche | Examinateur |
|---|---|---|
| LA HAYE | 09 AVRIL 1992 | GNUGESSER H.M. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
 
& : membre de la même famille, document correspondant

EPO FORM 1503 03.82 (P0402)

Office européen
des brevets

**RAPPORT DE RECHERCHE EUROPEENNE**

Numero de la demande

EP    91 40 3509
Page 2

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5 ) |
|---|---|---|---|
| A | PATENT ABSTRACTS OF JAPAN<br>vol. 13, no. 243 (E-768)7 Juin 1989<br>& JP-A-1 044 085 ( SEIKO EPSON CORP. )<br>* abrégé *<br>--- | 1,12,13 | |
| A | OPTICAL ENGINEERING.<br>vol. 29, no. 3, Mars 1990, BELLINGHAM US<br>pages 210 - 214;<br>J.L. JEWELL ET AL.: 'Surface-emitting microlasers for photonic switching and interchip connections'<br>* le document en entier *<br>----- | 1,12,13,<br>14 | |
| | | | **DOMAINES TECHNIQUES RECHERCHES (Int. Cl.5 )** |

Le présent rapport a été établi pour toutes les revendications

| Lieu de la recherche | Date d'achèvement de la recherche | Examinateur |
|---|---|---|
| LA HAYE | 09 AVRIL 1992 | GNUGESSER H.M. |